# EUROPÄISCHE PATENTSCHRIFT

(11) **EP 1 497 855 B1**
(45) Veröffentlichungstag und Bekanntmachung des Hinweises auf die Patenterteilung: **17.02.2010**
(21) Anmeldenummer: 03720280.1
(22) Anmeldetag: 22.04.2003
(51) Int. Cl.: H01L 21/20

(54) **VERFAHREN ZUR HERSTELLUNG EINER ODER MEHRERER EINKRISTALLINER SCHICHTEN MIT JEWEILS UNTERSCHIEDLICHER GITTERSTRUKTUR IN EINER EBENE EINER SCHICHTENFOLGE**
METHOD FOR PRODUCING ONE OR MORE MONOCRYSTALLINE LAYERS, EACH WITH A DIFFERENT LATTICE STRUCTURE, ON ONE PLANE OF A SERIES OF LAYERS
PROCEDE DE PRODUCTION D'UNE OU PLUSIEURS COUCHES MONOCRISTALLINES DOTEE CHACUNE D'UNE STRUCTURE RETICULAIRE DIFFERENTE DANS UN PLAN D'UNE SUITE DE COUCHES

(30) Priorität: 24.04.2002 DE 10218381
(43) Veröffentlichungstag der Anmeldung: 19.01.2005
(73) Patentinhaber: Forschungszentrum Jülich GmbH, 52425 Jülich (DE)
(72) Erfinder: MANTL, Siegfried, 52428 Jülich (DE); HOLLÄNDER, Bernhard, 51467 Bergisch Gladbach (DE); ZHAO, Quing-Tai, 52428 Jülich (DE)
(86) Internationale Anmeldenummer: PCT/DE2003/001315
(87) Internationale Veröffentlichungsnummer: WO 2003/092058

(56) Entgegenhaltungen:
- DE-A- 19 802 977
- US-A- 4 871 690
- US-A- 5 225 368
- HOLLANDER B ET AL: "Substrate engineering by hydrogen or helium implantation for epitaxial growth of lattice mismatched Si/sub 1-x/Ge/sub x/ films on silicon" 2000 INTERNATIONAL CONFERENCE ON ION IMPLANTATION TECHNOLOGY PROCEEDINGS. ION IMPLANTATION TECHNOLOGY - 2000 (CAT. NO.00EX432), 2000 INTERNATIONAL CONFERENCE ON ION IMPLANTATION TECHNOLOGY PROCEEDINGS. ION IMPLANTATION TECHNOLOGY - 2000, ALPBACH, AUS, Seiten 326-329, XP010543075 2000, Piscataway, NJ, USA, IEEE, USA ISBN: 0-7803-6462-7
- PATENT ABSTRACTS OF JAPAN vol. 2002, no. 07, 3. Juli 2002 (2002-07-03) -& JP 2002 094060 A (INTERNATL BUSINESS MACH CORP), 29. März 2002 (2002-03-29) -& US 6 429 061 B1 (RIM KERN) 6. August 2002 (2002-08-06)
- PATENT ABSTRACTS OF JAPAN vol. 2003, no. 03, 5. Mai 2003 (2003-05-05) -& JP 2002 343880 A (SHARP CORP), 29. November 2002 (2002-11-29)

## Beschreibung

Die Erfindung betrifft ein Verfahren zur Herstellung einer oder mehrerer einkristalliner Schichten mit jeweils unterschiedlicher Gitterstruktur in einer Ebene einer Schichtenfolge gemäß dem Oberbegriff des Anspruche 1. Des weiteren betrifft die Erfindung ein Bauelement gemäß Nebenanspruch.

Aus Holländer et al. (Holländer, B., Lenk, St., Mantl, S., Trinkhaus, H., Kirch, D., Lysberg, M., Herzog, H.-J. Hackbarth, T., Fichtner, P. F. P., "substrate Engineering by Hydrogen or Helium Implantation for Epitaxial Growth of Lattice Mismatched Si1-xGex Films on Silicon" 2000 INTERNATIONAL CONFERENCE ON ION IMPLANTATION TECHNOLOGY PROCEEDINGS. ION IMPLANTATION TECHNOLOGY - 2000 (CAT. NO.00EX432), 2000 INTERNATIONAL CONFERENCE ON ION IMPLANTATION TECHNOLOGY PROCEEDINGS. ION IMPLANTATION TECHNOLOGY - 2000, ALPBACH, AUS, Seiten 326-329, XP010543075 2000, Piscataway, NJ, USA, IEEE, USA ISBN: 0-7803-6462-7) ist ein Verfahren zur Herstellung von Siliziumgermaniumfilmen auf Siliziumsubstraten nach Ionenimplantation mit Wasserstoff- oder Heliumionen bekannt.

Häufig wird die Herstellung einkristalliner Schichten durch das zur Verfügung stehende Substratmaterial stark begrenzt, bzw. die Qualität der Schichten vermindert. Unterschiedliche Kristallstrukturen, sowie unterschiedliche Gitterparameter zwischen Substrat und Schichtmaterial (Gitterfehlanpassung) verhindern in der Regel ein einkristallines Wachstum von Schichten hoher Qualität. Ein für mikroelektronische Anwendungen besonders wichtiges Beispiel sind Silizium-Germanium-(SiGe)-Legierungen auf Silizium (Si). Werden bei nicht angepaßten Gitterparametern einkristalline Schichten abgeschieden, so hat dies zur Folge, daß diese anfangs mechanisch verspannt aufgewachsen werden, d.h. deren Gitterstruktur unterscheidet sich in diesem Zustand von oder eigenen. Überschreitet die abgeschiedene Schicht einen bestimmten Verspannungsgrad, so wird die mechanische Spannung durch Versetzungsbildung abgebaut und die Gitterstruktur kommt der eigenen näher. Diesen Prozeß nennt man Spannungsrelaxation, im folgenden "Relaxation" genannt.

Bei Schichtdicken, die für Bauelemente häufig erforderlich sind, werden durch diese Relaxation Versetzungen an der Grenzfläche zwischen der gebildeten Schicht und dem Substrat eingebaut, wobei aber auch nachteilig viele Versetzungen, von der Grenzfläche bis zur Schichtoberfläche verlaufen (sog. Threading-Versetzungen). Da sich die meisten dieser Versetzungen weiter durch neu aufgewachsene Schichten hindurch fortsetzen, verschlechtern sie die elektrischen und optischen Eigenschaften des Schichtmaterials erheblich.

Die rasch fortschreitende Informationstechnologie erfordert stetig schnellere Transistoren, insbesondere metal oxide field effect transistor (MOSFETs). Eine Leistungssteigerung wird in der Regel durch Verkleinerung der Transistordimensionen erzielt. Dies ist aber sehr aufwendig und teuer, da die Schlüsseltechnologien der Chip-Herstellung, wie die Lithographieverfahren und die Ätzverfahren durch leistungsfähigere Systeme ersetzt werden müssen. Ein alternativer Weg, ist die Verbesserung der Eigenschaften der verwendeten Materialien. Hier bietet sich insbesondere der Einsatz von verspanntem Silizium und verspanntem Siliziumgermanium (SiGe) an.

Die Verwendung von Silizium bzw. Siliziumgermanium (Si-Ge) in einem bestimmten elastischen Verzerrungszustand verbessert die Materialeigenschaften, insbesondere die für Bauelemente eminent wichtige Ladungsträgerbeweglichkeit der Elektronen und Löcher. Der Einsatz dieser und anderer höherwertigen Materialien erlaubt eine erhebliche Performancesteigerung von Si basierenden Hochleistungsbauelementen, wie MOSFET und MODFETs, ohne die kritischen Strukturgrößen der Bauelemente verändern zu müssen.

Da das Siliziumgermanium- (SiGe) -Materialsystem thermodynamisch ein völlig mischbares System ist kann die Verbindung in beliebiger Konzentration hergestellt werden. Silizium und Germanium zeichnen sich zwar durch gleiche Kristallstruktur aus, unterscheiden sich aber im Gitterparameter um 4,2%, d.h. daß eine SiGe-Schicht oder eine reine Ge-Schicht auf Silizium verspannt aufwächst.

Stand der Technik zur Herstellung von beispielsweise verspannungsfreien, qualitativ hochwertigen Siliziumgermanium- (SiGe)-Legierungsschichten auf Silizium-Substrat ist der Einsatz sog. "graded layer". Hierbei handelt es sich um SiGe-Schichten, deren Ge-Konzentration zur Oberfläche hin bis zur Erreichung des gewünschten Ge-Gehalts kontinuierlich oder stufenweise zunimmt. Da zur Einhaltung der Schichtqualität nur ein Anstieg des Ge-Gehalts von ca. 10 Atomprozent pro µm eingesetzt werden kann, sind solche Schichten, je nach erreichter Germaniumkonzentration bis zu 10 Mikrometer dick. Für das Schichtwachstum ist dies aus wirtschaftlicher und technologischer Sicht nicht befriedigend. Das Schichtwachstum dieser "graded layer" wird in E.A.Fitzgerald et al., Thin Solid Films, 294 (1997) 3, beschrieben. Zudem führt dieses Verfahren häufig zu hohen Schichtrauhigkeiten und unvollständiger Relaxation.

Aus DE19802977 ist ein Verfahren bekannt, das die Herstellung einer spannungsrelaxierten Oberflächenschicht mit guter Qualität erlaubt. Wird das Verfahren auf Si-Ge angewandt, kann damit eine dünne spannungsrelaxierte SiGe-Pufferschicht hergestellt werden, auf der durch epitaktische Abscheidung eine verspannte Si-Schicht erzeugt werden kann. Diese elastisch verspannten Siliziumschichten zeigen im Vergleich zu normalem Silizium eine erhöhte Elektronenbeweglichkeit. Dadurch sind sie für die Herstellung von n-Kanal-MOSFETs und n-Kanal-MODFET sehr interessant.

Um eine wesentlich verbesserte Löcherbeweglichkeit für p-Kanal Bauelemente zu erzielen, ist aber der gleichzeitige Einsatz von verspanntem SiGe bzw. Ge erforderlich. In DE19802977 wird vorgeschlagen, auf einer sehr dicken, gradierten, spannungsrelaxierten Si-Ge-Schicht eine weitere dünne verspannte Si-Ge -Schicht mit höherer Ge-Konzentration, sowie eine dünne verspannte Si abzuscheiden. Dadurch steht im Prinzip verspanntes Si und verspanntes Siliziumgermanium (SiGe) für n- und p-Kanal-Prozessierung zur Verfügung.
Nachteilig müssen mindestens 3 Schichten übereinander verwendet werden wodurch die gesamte Bauelementetechnologie erschwert wird. In dem komplizierten Heterosystem bilden sich parallel zu dem erwünschten Kanal parasitäre Leitfähigkeitskanäle aus, wodurch die Qualität der Bauelemente vermindert wird. Durch die Vielzahl der Schichten, insbesondere durch die sehr dicke, gradierte, spannungsrelaxierte Siliziumgermanium- (SiGe)-Schicht nimmt die Gesamtschichtdicke zu, so daß das Wärmeleitvermögen reduziert wird. Weiterhin ist durch die dicke, gradierte, spannungsrelaxierten Siliziumgermanium- (SiGe)-Schicht keine Planarität zwischen Si-Ge Bereich und Substratoberfläche erzielbar.

Aus Leitz et al. (Hole mobility enhancements in strained Si/Si1-yGeyp-type metal-oxide-semiconductor field-effect transistors grown on relaxed Si1-xGex (x<y) virtual substrates, 2001. Applied Physics Letters, Vol. 79, 4246-4248) sowie Cheng et al. (Relaxed Silicon-Germanium on insulator (SGOI), 2002. Mat. Res. Soc. Symp., Vol. 686, A1.5.1- A1.5.6) sind Verfahren zur Herstellung von Strukturen mit Waferbonden und Ätzen vorgestellt. Nachteilig sind diese Verfahren teuer und technologisch sehr aufwendig, da viele sehr anspruchsvolle Prozeßschritte umfaßt sind. Die in beiden Druckschriften beschriebenen Verfahren sind insbesondere bei großen Wafern (300 mm und größer) besonders schwierig anwendbar, da über eine sehr große Fläche die Schichtdicken und die Planarität des Wafers erhalten bleiben soll. Auch eine Verbiegung des Wafers, durch das Bonden erzeugter Spannungen, muß vermieden werden.

Aufgabe der Erfindung ist es ein Verfahren zur Herstellung einer oder mehrerer einkristalliner Schichten mit jeweils unterschiedlicher Gitterstruktur in einer Ebene bereit zu stellen, das die im Stand der Technik aufgezeigten Mängel nicht aufweist. Insbesondere sollen verschiedene Bereiche, mit beispielsweise verspanntem und unverspanntem Silizium, verspanntem und unverspanntem Siliziumgermanium (SiGe) oder anderen geeigneten Materialien mit jeweils unterschiedlicher Gitterstruktur in gleicher Ebene hergestellt werden und, unter Gewährleistung der Planarität für die weitere Prozesierung, beispielsweise für die Herstellung eines "system on a chip", einsetzbar sein.

Die Aufgabe wird durch ein Verfahren gemäß Hauptanspruch und durch ein Bauelement gemäß Nebenanspruch gelöst. Vorteilhafte Ausgestaltungen ergeben sich aus den darauf jeweils rückbezogenen Patentansprüchen.

Hierzu geht man von einer Schichtenfolge mit einem Substrat aus, in dessen Tiefe Isolationsbereiche vorliegen. In dem Substrat liegt nahe der Oberfläche partiell mindestens ein Defektbereich vor. Auf dem Substrat ist weiterhin zumindest partiell eine erste epitaktische Schicht angeordnet.
Diese Schichtenfolge wird so behandelt, daß nur der Bereich der ersten epitaktischen Schicht oberhalb des Defektbereichs spannungsrelaxiert, wohingegen die übrigen Bereiche dieser Schicht ihren Verspannungszustand beibehalten.
Dadurch erhält man unmittelbar mindestens eine erste epitaktische Schicht mit unterschiedlichem Verspannungszustand und damit unterschiedlicher Gitterstruktur in einer Ebene auf einem Substrat mit ebenfalls einer bestimmten Gitterstruktur.
Mit unterschiedlicher Gitterstruktur werden hier Materialien mit verschiedenen Gitterparametern oder verschiedenen Kristallstrukturen verstanden.

Die genannte Ausgangs-Schichtenfolge aus Substrat, Isolationsbereichen, Defektbereich und erster epitaktischer Schicht ist auf verschiedene Weise erhältlich. Es kann beispielsweise auf einem Substrat epitaktisch eine erste Schicht abgeschieden werden, sodann Isolationsbereiche in der Tiefe dieser Schichtenfolge hergestellt werden, und partiell ein Defektbereich unterhalb der Grenzfläche der abgeschiedenen Schicht erzeugt werden. An diese Reihenfolge der Prozessierung ist man allerdings nicht gebunden. Die Herstellung der Ausgangs-Schichtenfolge kann variiert werden, beispielsweise indem man den Defektbereich vor oder nach Abscheidung der ersten epitaktischen Schicht auf dem Substrat herstellt. Es ist weiterhin möglich auf einem Substrat eine laterale epitaktische Überwachsung von Isolatationsbereichen mit geeigneten Materialien durchzuführen.
Es sei erwähnt, daß weitere Schichten vorgesehen sein können, beispielsweise eine in der Praxis vorliegende dünne Übergangsschicht zwischen Substrat und erster epitaktischer Schicht aus dem gleichen Material wie das Substrat.

Ein großer Vorteil des Verfahrens ist, daß mit ganzflächigen Schichten bzw. Schichtsystemen begonnen werden kann und je nach Layout der mikroelektronischen Anwendungen, durch die ortsselektive Herstellung des Defektbereichs die Spannungsrelaxation nur an gewünschten Stellen eines großflächigen Wafers durchgeführt werden kann. Dies sind vorteilhaft ideale Bedingungen zur Realisierung eines "system on a chip", d. h. es werden dann aktive und passive Bauelemente (Transistoren unterschiedlicher Art, Spulen, Kondensatoren etc.) in einer Ebene hergestellt.

Die Defektbereiche können durch Ionenimplantation mit vorzugsweise leichten Ionen, z. B. Helium (DefektImplantation) in der Art erzeugt werden, daß die Ionen primär unterhalb der ersten epitaktischen Schicht vorlegen. Die Schichtenfolge wird thermisch so behandelt, bzw. das thermische Budget so klein gehalten, daß oberhalb der implantierten Bereichen des Substrats die erste epitaktische Schicht spannungsrelaxiert und oberhalb nicht implantierter Bereiche des Substrats die erste epitaktische Schicht ihren Verspannungszustand beibehalt. Es entstehen Blasen bzw. Hohlräume, die durch die Implantation, z. B. mit Helium und anschließendem Tempern erzeugt wurden, wodurch Versetzungen aus dem Defektbereich zur ersten epitaktischen Schicht laufen. Diese Versetzungen bewirken eine lokale Relaxation der ersten epitaktischen Schicht oberhalb des Defektbereichs. Es entsteht lokal begrenzt, eine dünne spannungsrelaxierte epitaktische Schicht mit geringen Kristallbaufehlern neben einer verspannten Schicht des gleichen Materials, die durch die Isolationsbereiche voneinander getrennt sind.

Die Relaxation kann auch durch eine Oxidation mit O₂ oder Wasser ausgelöst werden. Anstelle einer rein thermischen Behandlung zur Bildung verspannter und relaxierter Bereiche kann demnach eine Oxidation als Behandlung, oder auch eine Kombination von Oxidation und thermischer Behandlung ganzflächig oder mittels einer temperaturbeständigen Oxidationsbarrierenschicht, z. B. mittels einer Si₃N₄-Maske, eingesetzt werden. Hierdurch läßt sich auch lokal die Konzentration von Elementen, die für die Funktionsweise des Bauelements wichtig sind, innerhalb der ersten epitaktischen Schicht (z. B. Siliziumgermanium (SiGe)) erhöhen. Die bei der Spannungsrelaxation in den implantierten Bereichen entstehenden Versetzungen werden an einer Ausbreitung durch die Isolationsbereiche (z. B. STI oder LOCOS) lateral blockiert. Das Gleiten der Versetzungen nach oben ist für die Schichtrelaxation erforderlich und erfolgt daher nur an den Stellen, wo eine Relaxation erwünscht ist.

Das Verfahren nutzt Prozeßschritte, die in der Silizium-Technologie etabliert sind, so daß die Technologie auch auf sehr große Wafer (z. B. 300 mm Si-Wafer) übertragen werden kann, was z. B. mit Waferbonden, wie aus dem Stand der Technik bekannt, sehr schwierig ist.

Im Anschluß hieran kann mindestens eine weitere epitaktische Schicht auf dieser Schichtenfolge ganzflächig oder lokal begrenzt abgeschieden werden, sowie die erste epitaktische Schicht partiell von der Oberfläche entfernt werden. Hierdurch erhält man unmittelbar eine Schichtenfolge aus zwei Materialien mit relaxiertem und verspanntem Zustand "in einer Ebene". Die zuerst abgeschiedene epitaktische Schicht liegt, wie bereits erwähnt, in beiden Verspannungszuständen in einer Ebene vor, und zwar abhängig davon wo der Defektbereich erzeugt wurde. Das Substrat unterhalb der ersten epitaktischen Schicht liegt in relaxiertem Zustand vor. Das Material der zweiten abgeschiedenen Schicht auf der ersten epitaktischen Schicht liegt wiederum in verspanntem Zustand vor. Die abgeschiedene weitere Schicht kann aus dem gleichen Material sein wie das Substrat. Die abgeschiedene weitere Schicht kann auch aus dem gleichen Material sein wie die erste epitaktische Schicht, vorausgesetzt ein Bestandteil dieser Schicht weist eine andere Konzentration auf als in der ersten epitaktischen Schicht darunter. Da die erste epitaktische Schicht sehr dünn ist, z. B. kleiner als 50 Nanometer, ist gewährleistet, daß eine ausgezeichnete thermische Leitfähigkeit innerhalb der gesamten Schichtenfolge erhalten wird. Hierdurch ist beispielsweise die Bildung eines "system on a chip" möglich. Die Schichtenfolge aus erster epitaktischer Schicht und darauf abgeschiedener zweiter Schicht stellt auf Grund der Dünne der Schichten eine einzige Schicht in nahezu einer Ebene mit jeweils unterschiedlicher Gitterstruktur dar. Mit dem Begriff "in einer Ebene" ist demgemäß gemeint, daß die Höhe der durch Abscheidung oder Ätzung entstehenden Stufen bis zur Oberfläche des Substrats nicht größer sind als der Bereich der Tiefenschärfe der Abbildungsoptik der Lithographie. Dann ist gewährleistet, daß im Zuge weiterer Verfahrensschritte die Planarität innerhalb der Schichtenfolge ausreichend ist. Die Schichtenfolge aus erster epitaktischer Schicht und gegebenenfalls weiterer abgeschiedener Schicht weist z. B. eine Dicke von ca. 100 bis 200 Nanometer auf oder ist sogar noch dünner. Die Herstellung eines "system on a chip" (verschiedene Bauelemente mit verschiedenen Punktionen in einer Ebene) ist möglich. Hierzu können zunächst das Gate-Dielektrikum (z. B. SiO₂), Source und DrainKontakt, der Gate-Kontakt, und gegebenenfalls Spacer sowie darunter liegende anders dotierte Kanal-, Source- und Drain-Bereiche gefertigt und in einer Passivierungsschicht bzw. Isolatorschicht eingebettet werden. Dabei ist man nicht an bestimmte Transistortypen oder Bauteile gebunden.

Als leichtes Ion kann im Falle einer Ionenimplantation zur Herstellung des Defektbereiches insbesondere Helium gewählt werden. Es ist aber genauso gut möglich Wasserstoff, oder ein anderes Element z. B. aus der Gruppe der Edelgase, beispielsweise Argon auszuwählen. Diese Art von Ionen gewährleistet, daß unterhalb der Grenzfläche die gewünschten Versetzungen gebildet werden, ohne die epitaktische Schicht nachhaltig zu schädigen.

Es kann zudem eine weitere Implantation zur Bildung von Nukleationskeimen vorgesehen sein. Um die Dosis der zur Defekterzeugung implantierten He⁺- oder H⁺-Ionen zu reduzieren, kann eine weitere Implantation z. B. mit Silizium oder Germanium vorgeschaltet werden. Dadurch werden Nukleationskeime für die bei der Helium- oder Wasserstoff-Implantation entstehenden Bläschen gebildet, die deren Bildung begünstigen. Diese Vorgehensweise kann auch dann von Vorteil sein, wenn das Silizium auf einem SOI-Substrat unterhalb einer SiGe-Schicht so dünn ist, daß z. B. mit einer Helium-Implantation keine Bläschenschicht auf Grund der breiten Tiefenverteilung der implantierten He-Ionen erzeugt werden kann. Die höhere Masse von Silizium oder Germanium ermöglicht eine bessere Lokalisierung in der Tiefe. Die Bläschenbildung erfolgt dann bevorzugt an den mit der Silizium- bzw. Germanium-Implantation erzeugten Defekte.

Es kann auch eine weitere Wannen-Implantationen für die Bauelementherstellung vorgesehen sein.
Für die Herstellung von CMOS-Bauelementen (für komplementäre Logik) sind p- und n-dotierte Bereiche erforderlich, die mit Ionenimplantation, meist mit Bor, Arsen oder Phosphor, erzeugt werden. Diese sogenannten Wannenimplantationen, oder auch Retrograde-Well-Implantationen genannt, können vorteilhaft mit der selben Maske durchgeführt werden, die bereits für die Herstellung des Defektbereichs verwendet wurde. Zusätzlich können Implantationen zur Einstellung der Schwellspannung von MOSFETs mit dieser Maske durchgeführt werden. Dies verringert den Zeit- und Kostenaufwand zur Herstellung der Bauelemente.

Nach oder während der Fertigstellung der Bauelemente, z. B. Transistoren, kann an ausgewählten Isolationsbereichen (aus z.B. STI, deep trench, oder LOCOS) ein Trench an zumindest einer Seite eines Isolationsbereichs zumindest bis zur ersten epitaktischen Schicht geätzt werden. Die erste epitaktische Schicht (z. B. aus Siliziumgermanium (SiGe)) wird unter Ausnutzung von Masken z. B. durch Unterätzen selektiv entfernt wodurch vertikal und gegebenenfalls auch lateral ein Ätzgraben entsteht. Das verbleibende Material der Isolationsbereiche dient während der Unterätzung als selbstjustierender, lateraler Ätzstop. Bei Auswahl geeigneter Materialien erhält man vorteilhaft eine Schichtenfolge, die einem silicon on nothing (SON) entspricht. Das Verfahren ist für die Herstellung einer solchen Struktur besonders vorteilhaft geeignet.
Der entstandene Ätzgraben kann allerdings auch mit einem Isolator, z. B. SiO₂, aufgefüllt werden. Dann erhält man vorteilhaft eine Schichtenfolge, die einem silicon on insulator (SOI) bzw. einem Siliziumgermanium (SiGe) on insulator entspricht. Das Verfahren ist für die Herstellung einer solchen Struktur ebenfalls besonders geeignet.

Das Verfahren bietet in einer weiteren, besonders vorteilhaften Ausgestaltung der Erfindung das Potential zur weiteren Reduktion der Versetzungsdichte in der relaxierten und der verspannten Schicht.

Dies kann durch Ätzen der Gräben in den Schichten mit Mikrometer-Abständen beispielsweise von 1 bis 100 Mikrometer oder vorteilhafter, durch Ätzgräben, die an die Bauelementstrukturen angepasst sind, und nachfolgendes Tempern bei Temperaturen über 500°C erzielt werden. Fadenversetzungen in der Schicht gleiten dabei an den Rand dieser Bereiche und werden so ausgeheilt.

### Ausführungsbeispiele:

Im weiteren wird die Erfindung an Hand einiger Ausführungsbeispiele und der beigefügten Figuren näher beschrieben.

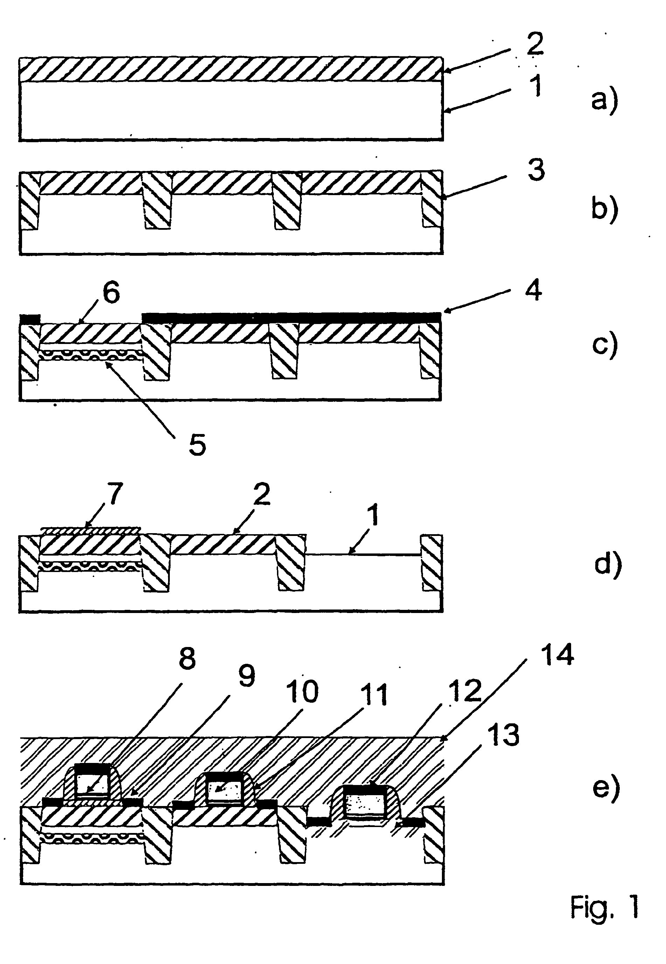

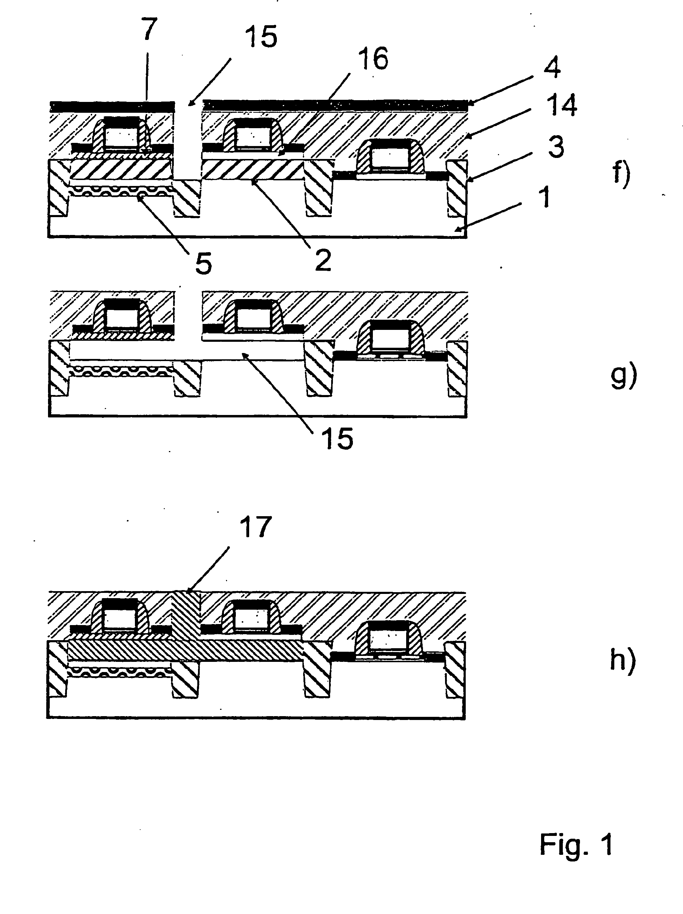

Figur 1 zeigt die Herstellung zweier einkristalliner Schichten mit jeweils unterschiedlicher Gitterstruktur in einer Ebene. Auf einem Silizium-Substrat 1 wird epitaktisch eine Siliziumgermanium- (SiGe)-Schicht 2 abgeschieden (Figur 1a). Es kann eine dünne Übergangsschicht aus Silizium zwischen beiden Schichten vorgesehen sein.
Sodann werden STI-Isolationsbereiche 3 in der Tiefe dieser Schichtenfolge hergestellt. In Figur 1b ist nur der Rechte von insgesamt vier Isolationsbereichen 3 mit einem Pfeil markiert. Die vier Isolationsbereiche 3 dienen im weiteren Verfahren bei Unterätzungsprozessen als selbstjustierende laterale Ätzstops. Man ist an dies Reihenfolge der Prozessierung nicht gebunden. Man kann genauso gut bereits von einem gewerblich erhältlichen Substrat mit festgelegten Isolationsbereichen 3 ausgehen. In einem solchen Substrat 1 kann ein Defektbereich 5 z. B. durch Ionenimplantation oder Abscheidung erzeugt werden und sodann die Siliziumgermanium-(SiGe)-Schicht 2 abgeschieden werden.
Nach Aufbringen einer Maske 4 erfolgt eine Heliumionen-Implantation beilspielsweise mit einer Energie von ca. 18 keV und einer Dosis von 2×0¹⁶ cm⁻² bei 100 nm Schichtdicke der Siliziumgermanium- (SiGe)-Schicht 2. Die Maske wird vor der Temperung in der Regel entfernt. Die implantierten Ionen erzeugen primär unterhalb der Siliziumgermanium- (SiGe) -Schicht einen Defektbereich 5.
Anschließend erfolgt eine Temperung als thermische Behandlung bei 850 °C für 10 Minuten in einer inerten N₂-Atmosphäre. Es kann auch ein anderes z. B. inertes Gas (z.B. Argon) oder ein Gas, das für die Zwecke der Erfindung geeignet ist, verwendet werden (z. B. O₂). Über dem Defektbereich 5 entsteht bei diesem Temperaturregime, das nicht zu hoch gewählt sein darf, eine spannungsrelaxierte Siliziumgermanium (SiGe)-Schicht 6. In den Bereichen in denen die Schichtenfolge durch Maske 4 maskiert war, liegt nach der Temperaturbehandlung verspanntes Siliziumgermanium (SiGe) 2 vor (Fig. 1d). Teile der vorab maskierten Siliziumgermanium- (SiGe)-Schicht werden z. B. durch Ätzung entfernt (Fig. 1d: siehe entfernter rechter Teil der Schicht 2)). Dort liegt dann unverspanntes, d.h. relaxiertes Silizium 1 an der Oberfläche der Schichtenfolge vor.
Wird das Siliziumgermanium (SiGe) 2 von Anfang an in Figur 1b nur partiell auf dem Substrat 1 abgeschieden, so liegt an den nicht mit Siliziumgermanium (SiGe) abgeschiedenen Bereichen ebenfalls unverspanntes Silizium 1 als Substrat an der Oberfläche der Schichtenfolge vor. Dadurch, daß nur eine sehr dünne Schicht der zuerst abgeschiedenen Schicht 2 (Siliziumgermanium (Si-Ge)) aufgebracht wurde, liegen neben verspanntem und relaxiertem siliziumgermanium (SiGe) 2, 6 auch unverspanntes Silizium 1 "in einer Ebene" vor.

Im Sinne der Erfindung bedeutet "eine Ebene", daß eine ausreichende Planarität der verschiedenen Schichten 1, 2, 6 für die anschließenden verfahrensschritte, z. B. für die Lithographie, vorliegt, sowie die thermische Gleitfähigkeit zum Substrat 1 gewährleistet ist. Erfindungsgemäße Schichtenfolgen auf dem Substrat 1 können wie im ersten Ausführungsbeispiel eine Dicke von ca. 100 bis 200 Nanometer oder weniger aufweisen um diese Anforderungen zu erfüllen.

Es kann, zumindest partiell, eine weitere Schicht 7 epitaktisch auf der relaxierten Siliziumgermanium-(SiGe)-Schicht 6 aufgebracht werden (Fig. 1d). Diese weitere abgeschiedene Schicht 7 ist dann verspannt. Sie kann z. B. aus Silizium, oder auch aus Siliziumgermanium (SiGe) mit anderer Germaniumkonzentration als in der ersten epitaktischen Schicht 6 darunter, oder auch aus einer Vielfachschicht bestehen. Im Falle von Silizium, liegt verspanntes Silizium 7 und unverspanntes Silizium 1 "in einer Ebene" vor. Das verspannte Silizium 7 liegt zwar formal oberhalb der relaxierten Siliziumgermanium-(SiGe)-Schicht 6, welche wiederum neben der verspannten Siliziumgermanium-(SiGe)-Schicht 2 liegt. Durch die Dünne der Schichten 2 und 6 ist jedoch die Planarität der verschiedenen Bereiche der Schichten 1, 2, 6 und 7 sowie die thermische Leitfähigkeit zum Substrat 1 gewährleistet.

Schicht 1 aus Fig. 1d (unverspanntes Si) kann zur Herstellung konventioneller Si-Bauelemente, wie MOSFETs verwendet werden.
Schicht 7 aus Fig. 1d (verspanntes Si) kann auf Grund der höheren Beweglichkeiten der Elektronen zur Herstellung von ultraschnellen MOSFETs, insbesondere n-Kanal MOSFETs verwendet werden.
Schicht 2 aus Fig. 1d (verspanntes Siliziumgermanium (SiGe)) kann auf Grund der hohen Beweglichkeit der Löcher vorteilhaft zur Herstellung von ultraschnellen p-Kanal MOSFET verwendet werden.
Schicht 6 aus Fig. 1d (unverspanntes Siliziumgermanium (SiGe)) kann auf Grund der etwas höheren Beweglichkeit der Löcher vorteilhaft zur Herstellung von ultraschnellen p-Kanal MOSFET verwendet werden.

Man kann darüber hinaus auch von anderen Schichtenfolgen und Prozessierungen ausgehen:

Beispiel: Auf einem Substrat 1 (z. B. Silizium, Siliziumgermanium (SiGe), Saphir oder geeignete Perovskite) wird eine laterale epitaktische Überwachsung mit geeigneten Materialien (z. B. AlN oder Siliziumgermanium (SiGe)) für die Überwachsung der Isolationsbereiche durchgeführt.

Neben Siliziumgermanium (SiGe) als erste epitaktische Schicht 2 können desweiteren allgemein III-V-Verbindungen, insbesondere III-V-Nitride (GaN, AlN, InN) sowie auch oxidische Perovskite als erste epitaktische Schicht 2 angeordnet sein. Wichtig ist in jedem Fall nur, daß geeignete Materialien auf einem geeigneten Substrat angeordnet werden, so daß mindestens eine Schicht 2, 6 mit unterschiedlicher Gitterstruktur, getrennt durch Isolationsbereiche 3, auf diesem Substrat hergestellt werden kann.

Im weiteren werden demgemäß die verschiedenen Bauelemente, z. B. Transistoren in einer Ebene (system on a chip) gefertigt (Fig. 1e) und in eine Passivierungsschicht 14 eingebettet. Die Versetzung der Bauelemente in der Höhe der Fig. 1e dient ausschließlich der besseren Darstellbarkeit der verschiedenen Prozesse. Tatsächlich jedoch sind die Bauelemente als in einer Ebene im Sinne der Erfindung zu verstehen.

Nach der Fertigung der Bauelemente können selektiv bestimmte Isolationsbereiche 3, bzw. Teile davon, durch Ätzen unter Ausnutzung einer weiteren Maske 4 entfernt werden. Die Ätzung erfolgt zunächst zumindest bis in eine Tiefe zur ersten epitaktischen Schicht 2, bzw. 6, z. B. bis zu deren Unterkante (Fig. 1f). Es entsteht ein zunächst vertikaler Ätzgraben 15. Dann werden die spannungsrelaxierte Siliziumgermanium- (SiGe)-Schicht 6 und/oder die verspannte Siliziumgermanium- (SiGe)-Schicht 2 entfernt.
Schicht 16 in Fig. 1f (z. B. unverspanntes Silizium) entstünde in Fig. 1d bei Abscheidung von Silizium auf dem Siliziumgermanium (SiGe) 2. Diese Schicht ist in Fig. 1d und Fig. 1e nicht gezeigt. Maske 4 in Fig. 1c wäre zur Abscheidung hierzu über dem mittleren Teil der Schicht 2 geöffnet.
Durch seitliches Unterätzen der Schichten 7 (z. B. verspanntes Silizium) und 16 (z. B. unverspanntes Silizium, unverspanntes Siliziumgermanium (SiGe) mit anderer Germaniumkonzentration als in der Schicht 2 darunter) werden die Schichten 2 und 6 entfernt und der Ätzgraben 15 wird horizontal fortgeführt, wobei das STI 3 an den Seiten als selbstjustierender Ätzstop dient (Fig. 1g). Dies hat zur Folge, daß die elektrische Leitfähigkeit zum Substrat 1 unterbunden wird.

Die für die Spannungsrelaxation der Siliziumgermanium-(SiGe)-Schicht 2 erforderliche Bildung und Ausbreitung von Versetzungen wird durch die Isolationsbereiche 3 also lateral begrenzt, so daß die relaxierte Siliziumgermanium- (SiGe)-Schicht 6 entsteht. Dadurch wird das Ausbreiten von Versetzungen in Nachbarbereiche ausgeschlossen.

Die entstandenen Ätzgräben 15 können weiter mit Isolatorschicht 17, z. B. mittels CVD-Abscheidung mit z. B. SiO₂ aufgefüllt werden (Fig. 1h). So wird ein Bauelement mit einer Schichtenfolge bereit gestellt, welches lokal die Funktion eines silicone on insulator- (SOI) Substrates (bzw. Siliziumgermanium (SiGe) on insulator) aufweist ohne allerdings diese teueren Substrate zu verwenden.

In dem Fall, daß der entstandene Ätzgräben 15 in Fig. 1g nur in der vertikalen mit einer Isolatorschicht 17 aufgefüllt wird, wird ein Bauelement mit einer Schichtenfolge bereit gestellt, welches lokal der Funktion eines silicon on nothing- (SON)-Substrates entspricht.

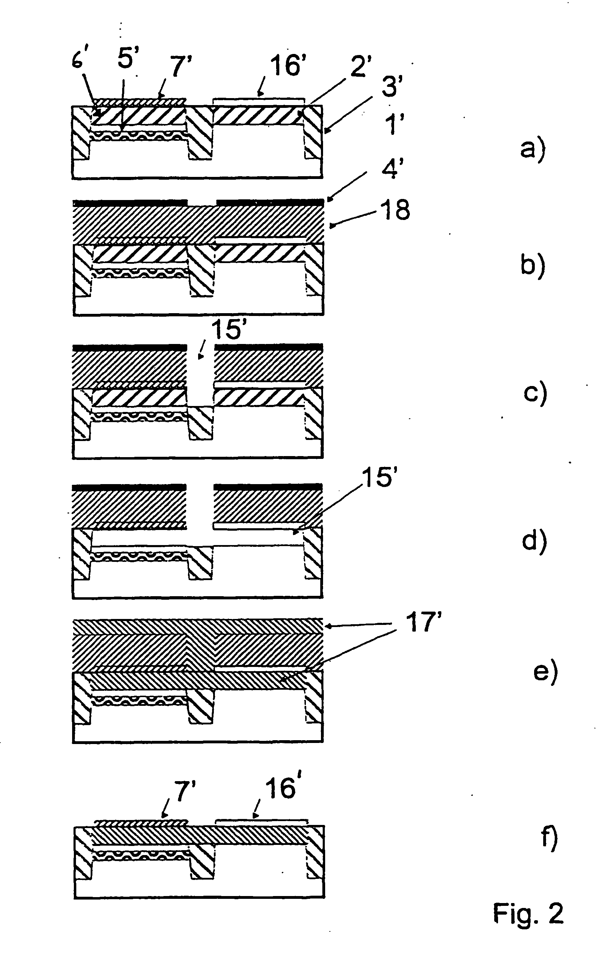

In Figur 2 sind nur drei in der Tiefe angeordnete Isolationsbereiche 3 (nur der rechte ist mit einem Pfeil markiert) dargestellt.
Figur 2a zeigt, ausgehend von der Schichtenfolge aus Fig. 1c bzw. 1d und unter Ausnutzung von Maskentechnologie (nicht dargestellt) die Aufbringung einer weiteren Schicht unverspannten Siliziums 16' auf der Schicht verspannten Siliziumgermaniums (SiGe) 2'. Weiterhin ist verspanntes Silizium 7' auf unverspanntem, relaxiertem Siliziumgermanium (SiGe) 6' angeordnet. Eine Versteifungsschicht 18 und hierauf eine Maske 4' werden auf dieser Schichtenfolge angeordnet (Fig. 2b). Die Versteifungsschicht 18 dient zur Stabilisierung der Schichtenfolge. Maske 4' ist derart angeordnet, daß ein Ätzgraben 15' bis zur Unterkante der Schicht 2' und/oder 6' geätzt werden kann (Fig. 2c; die Bezugszeichen dieser Schichten sind nicht dargestellt und werden aus Fig. 2a übernommen). Schichten 2' und/oder 6' werden vollständig durch Ätzen entfernt (Fig. 2d). Die Maske 4' wird entfernt und der Ätzgraben 15' wird vollständig in der vertikalen und in der horizontalen mit einem Isolator 17' aufgefüllt (Fig. 2e). Anschließend wird die Versteifungsschicht 18 sowie darauf aufliegendes Isolatormaterial 17' entfernt. Es entsteht eine Schichtenfolge gemäß Fig. 2f.

Danach kann eine Prozessierung der Bauelemente wie in der Figur 1e bis zur Herstellung der Bauelemente, z. B. Transistoren fortgeführt werden.

Der Unterschied zur Prozessierung in Figur 1 besteht demgemäß darin, daß die Auffüllung der Ätzgräben 15' mit Isolator 17' in Fig. 2 also vor der Herstellung der Bauelemente (z. B. Transistoren) erfolgt, während gemäß Figur 1 zunächst die verschiedenen Bauelemente hergestellt werden und sodann die Ätzgräben 15 mit Isolator 17 hergestellt werden.

Die in Figur 1 dargestellten Bauelemente sind selbstverständlich nur exemplarisch. Es können statt der dargestellten aktiven drei Bauelemente (Transistoren) auch passive Bauelemente jedweder Art (Spulen, Kondensatoren, Widerstände etc.) zur weiteren Prozessierung des "system on a chip" integriert werden.

Die nach einem der erfindungsgemäßen Verfahren hergestellten Schichtenfolgen können insbesondere zur Herstellung von modulated doped Feldeffekt-Transistor (MODFET) oder metal-oxide-semiconductor Feldeffekt-Transistor (MOSFET) herangezogen werden.

Es ist auch möglich, resonante Tunneldioden, insbesondere eine resonante Siliziumgermanium (SiGe)-Tunneldiode, herzustellen.

Weiterhin ist denkbar, einen Photodetektor aus einer der Schichtenfolgen herzustellen.

Weiterhin ist denkbar, ausgehend von einer Schichtenfolge von GaAs als zweiter abgeschiedener Schicht 7, 7' auf einer ersten epitaktischen Schicht aus Siliziumgermanium (SiGe) 2, 2', 6, 6', einen Laser herzustellen.

### Bezugszeichenliste:

- 1, 1': Substrat
- 2, 2': Epitaktische Schicht, (z. B. Siliziumgermanium)
- 3, 3': Shallow Trench Isolation (STI) z. B. aus SiO₂
- 4, 4': Photolackmaske
- 5, 5': Defektbereich
- 6, 6': Spannungrelaxierte Schicht aus dem Material der ersten epitaktischen Schicht (z. B. SiGe)
- 7, 7': Abgeschiedene Silizium- oder SiGe- oder Vielfachschicht, z. B. verspanntes Silizium
- 8: Gatedielektrikum, z. B SiO₂ oder alternatives Gatedielektrikum
- 9: Metallischer Source bzw. Drainkontakt, z. B. CoSi₂, NiSi, TiSi₂ oder andere geeignete Materialien
- 10: Polysilizium oder metallischer Gatekontakt
- 11: Spacer z. B. SiO₂ oder/und SiN
- 12: Metallischer Gatekontakt, z. B. CoSi₂, NiSi
- 13: Dotierte Source bzw. Drain-Bereiche
- 14: Passivierungs- bzw. Isolationsschicht
- 15, 15': Ätzgraben
- 16, 16': Unverspanntes Silizium oder Siliziumgermanium (SiGe) anderer Germaniumkonzentration als gegebenenfalls in der Schicht 2
- 17, 17': Isolator (z. B. SiO₂)
- 18: Versteifungsschicht

## Patentansprüche

1. Verfahren zur Herstellung einer einkristallinen epitaktischen Schicht (2, 2'; 6, 6') mit lokal unterschiedlichem Verspannungszustand auf einem Substrat (1, 1'), bei dem eine Schichtenfolge aus Substrat (1, 1') und einer auf dem Substrat verspannt angeordneten ersten epitaktischen Schicht (2, 2'; 6, 6'), wobei Isolationsbereiche (3,3') entweder von der Oberfläche der ersten epitaktischen Schicht oder der Grenzfläche zwischen Substrat und erster epitaktischen Schicht in die Tiefe des Substrats (1, 1') führen, und wobei im Substrat nahe der Grenzfläche (1, 1') zur ersten epitaktischen Schicht (2, 2'; 6, 6') lokal mindestens ein durch Ionenimplantation erzeugter Defektbereich (5, 5') zwischen Isolationsbereichen (3, 3') angeordnet ist, thermisch bei niedriger Temperatur so behandelt wird, dass lokal nur die Bereiche (6, 6') der ersten epitaktischen Schicht oberhalb des mindestens einen Defektbereichs (5, 5') spannungsrelaxieren, wohingegen die übrigen Bereiche (2, 2') der ersten epitaktischen Schicht ihren Verspannungszustand beibehalten.

2. Verfahren nach Anspruch 1,
**dadurch gekennzeichnet, dass**
eine Schichtenfolge behandelt wird, bei welcher die Isolationsbereiche (3, 3') ausgehend von der Oberfläche der ersten epitaktischen Schicht in die Tiefe des Substrats hineinführen.

3. Verfahren nach einem der Ansprüche 1 oder 2,
**dadurch gekennzeichnet, dass**
eine Schichtenfolge behandelt wird, bei welcher der mindestens eine Defektbereich (5, 5') mittels einer Maske gebildet wurde.

4. Verfahren nach einem der Ansprüche 1 bis 3,
**dadurch gekennzeichnet, dass**
eine Schichtenfolge behandelt wird, bei welcher der mindestens eine Defektbereich (5, 5') durch eine Ionenimplantation mit Helium-Ionen, oder Wasserstoff-, Bor-, Phosphor-, Arsen-, Silizium-, Germanium-, Antimon-, Schwefel, Neon-, Argon- oder Xenon-Ionen gebildet wurde.

5. Verfahren nach Anspruch 4,
**dadurch gekennzeichnet, dass**
eine Schichtenfolge behandelt wird, bei welcher der mindestens eine Defektbereich (5, 5') durch eine Helium- oder Wasserstoff-Ionenimplantation erzeugt wurde und vor der Helium- oder Wasserstoff-Ionenimplantation eine Implantation mit Silizium, Germanium oder inerten Gasen zur Nukleation von Helium- oder Wasserstoffbläschen durchgeführt wurde.

6. Verfahren nach einem der vorhergehenden Ansprüche,
**gekennzeichnet durch**
Wahl einer Schichtenfolge mit insbesondere Silizium, oder Siliziumgermanium (SiGe), SiC, Saphir oder einem oxidischen Perovskit als Substrat (1, 1').

7. Verfahren nach einem der vorhergehenden Ansprüche,
**gekennzeichnet durch**
Wahl einer Schichtenfolge mit insbesondere Siliziumgermanium (SiGe), oder Verbindungshalbleitern der III-V-Gruppe, der III-V-Nitride (AlN, GaN, oder InN) oder der II-VI-Gruppe des Periodensystems, oder oxidischen Perovskiten als Material der ersten epitaktischen Schicht (2, 2', 6, 6').

8. Verfahren nach Anspruch 6 oder 7,
**gekennzeichnet durch**
eine thermische Behandlung von 10 Minuten bei 850 °C in einer N₂₋ Atmosphäre zur Spannungsrelaxation von Siliziumgermanium als erste epitaktische Schicht (2) auf einem Siliziumsubstrat (1).

9. Verfahren nach Anspruch 6 oder 7,
**gekennzeichnet durch**
eine thermische Behandlung in einer Argon- oder O₂-Atmosphäre zur Spannungsrelaxation von Siliziumgermanium als erste epitaktische Schicht (2) auf einem Siliziumsubstrat (1).

10. Verfahren nach einem der vorhergehenden Ansprüche,
**dadurch gekennzeichnet, dass**
nach der thermischen Behandlung Teile der verspannten Bereiche der ersten epitaktischen Schicht so entfernt werden, dass das darunter liegende Substrat freigelegt wird und spannungsrelaxierte Bereiche der ersten epitaktischen Schicht oberhalb des mindestens einen Defektbereichs in einer Ebene neben verspannten Bereichen der ersten epitataktischen Schicht und neben spannungsrelaxierten Substrat liegen.

11. Verfahren nach einem der vorhergehenden Ansprüche,
**dadurch gekennzeichnet, dass**
nach der thermischen Behandlung mindestens eine weitere, zweite epitaktische Schicht (7, 7'), insbesondere aus Silizium oder aus Siliziumgermanium mit zur ersten epitaktischen Siliziumgermaniumschicht verschiedenem Germaniumgehalt ganzflächig oder lokal auf der Schichtenfolge verspannt abgeschieden wird.

12. Verfahren nach Anspruch 11,
**dadurch gekennzeichnet, dass**
die erste epitaktische Schicht eine verspannte SiGe-Schicht ist, auf der lokal begrenzt mindestens eine weitere epitaktische Siliziumschicht unverspannt abgeschieden wird.

13. Verfahren nach Anspruch 11,
**gekennzeichnet durch**
eine Dicke der ersten epitaktischen Schicht zusammen mit der zweiten epitaktischen Schicht von etwa 100 bis 200 Nanometern, so dass die Planarität der verschiedenen Silizium- und Siliziumgermaniumbereiche (1, 2, 6, 7) sowie die thermische Leitfähigkeit zum Substrat (1) gewährleistet ist.

14. Verfahren nach einem der vorhergehenden Ansprüche 11 bis 13,
bei dem eine Versteifungsschicht (18) zur Stabilisierung der Schichtenfolge auf dieser abgeschieden wird, wobei die Versteifungsschicht insbesondere über einer Schicht unverspannten Siliziums (16') auf verspannten Siliziumgermanium (2') sowie einer daneben angeordneten Schicht verspannten Siliziums (7') auf spannungsrelaxiertem Siliziumgermanium (6') abgeschieden wird.

15. Verfahren nach Anspruch 14,
**gekennzeichnet durch**
Abscheidung einer Maske (4') auf der Versteifungsschicht (18).

16. Verfahren nach einem der vorhergehenden Ansprüche 11 bis 13,
**gekennzeichnet durch**
shallow trench Isolationen (STI), deep trench isolationen oder LOCOS als Isolationsbereiche (3, 3').

17. Verfahren nach Anspruch 11,
**dadurch gekennzeichnet, dass**
als zweite epitaktische Schicht (7, 7') eine Germaniumschicht oder eine Mehrfachschicht ganzflächig oder selektiv abgeschieden wird.

18. Verfahren nach Anspruch 11,
**dadurch gekennzeichnet, dass**
im Falle von Siliziumgermanium (SiGe) als zweiter epitaktischer Schicht (7, 7') auf Siliziumgermanium (SiGe) als erster epitaktischer Schicht (6, 6') die Germaniumkonzentration der zweiten epitaktischen Siliziumgermaniumschicht (7, 7') höher ist als in der ersten epitaktischen Siliziumgermaniumschicht (6, 6').

19. Verfahren nach einem der vorhergehenden Ansprüche 11 bis 13,
**dadurch gekennzeichnet, dass**
eine Wannen-Implantationen für eine Bauelementherstellung und die Defektimplantation für die Spannungsrelaxation mit derselben Maske durchgeführt wird.

20. Verfahren nach einem der vorhergehenden Ansprüche 11 bis 13,
**dadurch gekennzeichnet, dass**
ausgewählte Isolationsbereiche (3, 3') zumindest bis in die Tiefe der ersten epitaktischen Schicht (2, 2', 6, 6'), insbesondere durch Ätzung, entfernt werden.

21. Verfahren nach einem der vorhergehenden Ansprüche 11 bis 13,
**dadurch gekennzeichnet, dass**
die erste epitaktische Schicht (2, 2', 6, 6') zumindest lokal entfernt wird, um verspanntes Silizium auf "nothing" - (silicon on nothing, SON) zu erzeugen.

22. Verfahren nach Anspruch 21,
**dadurch gekennzeichnet, dass**
die aus der ersten epitaktischen Schicht (2, 2', 6, 6') entfernten Bereiche mit einem Isolator (17, 17') aufgefüllt werden, um silicon on insulator (SOI) zu erzeugen.

23. Verfahren nach einem der vorhergehenden Ansprüche 11 oder 13,
**dadurch gekennzeichnet, dass**
die zweite epitaktische Schicht Silizium ist und in dieser Schicht (7) n-Kanal MOSFETS prozessiert werden.

24. Verfahren nach einem der vorhergehenden Ansprüche 11 oder 13,
**dadurch gekennzeichnet, dass**
die zweite epitaktische Schicht Siliziumgermanium ist und in dieser Schicht (7) p-Kanal MOSFETs prozessiert werden.

25. Bauelement mit einer Schichtenfolge, umfassend eine einkristalline epitaktische Schicht (2, 2'; 6, 6') mit lokal unterschiedlichem Verspannungszustand auf einem Substrat (1, 1'), wobei Isolationsbereiche (3, 3') entweder von der Oberfläche der epitaktischen Schicht oder der Grenzfläche zwischen Substrat und epitaktischer Schicht in die Tiefe des Substrats (1,1') führen, und wobei im Substrat nahe der Grenzfläche (1, 1') zur epitaktischen Schicht (2, 2'; 6, 6') lokal mindestens ein durch Ionenimplantation erzeugter Defektbereich (5, 5') zwischen den Isolationsbereichen (3, 3') angeordnet ist und die Bereiche (6, 6') der epitaktischen Schicht oberhalb des mindestens einen Defektbereichs (5, 5') spannungsrelaxiert sind, wohingegen die übrigen Bereiche (2, 2') der epitaktischen Schicht verspannt sind.

## Claims

1. Method for producing a monocrystalline epitactic layer (2, 2'; 6, 6') with locally varying states of stress on a substrate (1, 1'), in which a series of layers made of substrate (1, 1') and a first epitactic layer (2, 2'; 6, 6') arranged under stress on the substrate, in which insulation areas (3, 3') of either the surface of the first epitactic layer or the bordering area between the substrate and first epitactic layer lead go deep into the substrate (1, 1') and in which in the substrate near the bordering area (1, 1') with the first epitactic layer (2, 2'; 6, 6') locally at least one defect area (5, 5') produced by ion implantation is arranged between insulation areas (3, 3'), is heat treated at low temperature so that locally only the areas (6, 6') of the first epitactic layer are stress relaxed above the at least one defect area (5, 5'), in contrast to which the other areas (2, 2') of the first epitactic layer maintain their state of stress.

2. Method according to claim 1,
**characterised in that**
a series of layers is treated, in which the insulation areas (3, 3') penetrate deep into the substrate from the surface of the first epitactic layer.

3. Method according to one of claims 1 or 2,
**characterised in that**
a series of layers is treated, in which the at least one defect area (5, 5') was formed by means of a mask.

4. Method according to one of claims 1 to 3,
**characterised in that**
a series of layers is treated, in which the at least one defect area (5, 5') was formed through ion implantation with helium ions or hydrogen, boron, phosphorous, arsenic, silicon, germanium, antimony, sulphur, neon, argon or xenon ions.

5. Method according to claim 4,
**characterised in that**
a series of layers is treated, in which the at least one defect area (5, 5') was produced through helium or hydrogen ion implantation and implantation with silicon, germanium or inert gases for the nucleation of helium or hydrogen bubbles was carried out before helium or hydrogen ion implantation.

6. Method according to one of the previous claims,
**characterised by**
the selection of a series of layers with silicon or silicon germanium (SiGe), SiC, sapphire or an oxidic perovskite as substrate (1, 1') in particular.

7. Method according to one of the previous claims,
**characterised by**
the selection of a series of layers with silicon germanium (SiGe) or connecting semiconductors of the III-V group, III-V nitrides (AlN, GaN, or InN) or the II-VI group of the periodic system or oxidic perovskites as the material of the first epitactic layer (2, 2', 6, 6') in particular.

8. Method according to claim 6 or 7,
**characterised by**
thermal treatment for 10 minutes at 850° C in an N₂ atmosphere for stress relaxation of silicon germanium as the first epitactic layer (2) on a silicon substrate (1).

9. Method according to claim 6 or 7,
**characterised by**
thermal treatment in an argon or O₂ atmosphere for stress relaxation of silicon germanium as the first epitactic layer (2) on a silicon substrate (1).

10. Method according to one of the previous claims,
**characterised in that**
after thermal treatment parts of the stressed areas of the first epitactic layer are removed so that the substrate lying underneath is exposed and stress-relaxed areas of the first epitactic layer lie above the at least one defect area on one plane next to stressed areas of the first epitactic layer and next to the stress-relaxed substrate.

11. Method according to one of the previous claims,
**characterised in that**
after thermal treatment at least one further, second epitactic layer (7, 7'), particularly made of silicon or silicon germanium with a different germanium content to the first epitactic silicon germanium layer, is precipitated under stress on the series of layers over the whole area or locally.

12. Method according to claim 11,
**characterised in that**
the first epitactic layer is a stressed SiGe layer, on which at least one further epitactic silicon layer is precipitated without stress in a locally limited way.

13. Method according to claim 11,
**characterised by**
a thickness of the first epitactic layer together with the second epitactic layer of about 100 to 200 nanometres, so that the planarity of the various silicon and silicon germanium areas (1, 2, 6, 7) and thermal conductivity to the substrate (1) is ensured.

14. Method according to one of the previous claims 11 to 13,
in which a stiffening layer (18) for stabilising the series of layers is precipitated on it, in which the stiffening layer is precipitated over a layer of unstressed silicon (16') on stressed silicon germanium (2') and a layer of stressed silicon (7') arranged next to it on stress-relaxed silicon germanium (6') in particular.

15. Method according to claim 14,
**characterised by**
precipitation of a mask (4') on the stiffening layer (18).

16. Method according to one of the previous claims 11 to 13,
**characterised by**
shallow trench insulation (STI), deep trench insulation or LOCOS as insulation areas (3, 3').

17. Method according to claim 11,
**characterised in that**
a germanium layer or multiple layer is precipitated over the whole area or selectively as a second epitactic layer (7, 7').

18. Method according to claim 11,
**characterised in that**
in the case of silicon germanium (SiGe) as a second epitactic layer (7, 7') on silicon germanium (SiGe) as a first epitactic layer (6, 6') the germanium concentration of the second epitactic silicon germanium layer (7, 7') is higher than in the first epitactic silicon germanium layer (6, 6').

19. Method according to one of the previous claims 11 to 13,
**characterised in that**
tank implantation is carried out with the same mask for producing construction elements and defect implantation for stress relaxation.

20. Method according to one of the previous claims 11 to 13,
**characterised in that**
selected insulation areas (3, 3') are removed at least until deep in the first epitactic layer (2, 2', 6, 6'), particularly by etching.

21. Method according to one of the previous claims 11 to 13,
**characterised in that**
the first epitactic layer (2, 2', 6, 6') is removed at least locally in order to produce stressed silicon on "nothing" - (silicon on nothing, SON).

22. Method according to claim 21,
**characterised in that**
the areas removed from the first epitactic layer (2, 2', 6, 6') are filled with an insulator (17, 17') in order to produce silicon on insulator (SOI).

23. Method according to one of the previous claims 11 or 13,
**characterised in that**
the second epitactic layer is silicon and n-channel MOSFETs are processed in this layer (7).

24. Method according to one of the previous claims 11 or 13,
**characterised in that**
the second epitactic layer is silicon germanium and p-channel MOSFETs are processed in this layer (7).

25. Construction element with a series of layers, comprising a monocrystalline epitactic layer (2, 2'; 6, 6') with locally varying states of stress on a substrate (1, 1'), in which insulation areas (3, 3') of either the surface of the epitactic layer or the bordering area between the substrate and the epitactic layer go deep into the substrate (1, 1') and in which in the substrate near the bordering area (1, 1') with the epitactic layer (2, 2'; 6, 6') locally at least one defect area (5, 5') produced by ion implantation is arranged between the insulation areas (3, 3') and the areas (6, 6') of the epitactic layer are stress-relaxed above at least one defect area (5, 5'), in contrast to which the other areas (2, 2') of the epitactic layer are stressed.

## Revendications

1. Procédé de préparation d'une couche monocristalline épitactique (2, 2' ; 6, 6') avec des états de tension localement différents, sur un substrat (1, 1'), dans lequel une suite de couches constituée du substrat (1, 1') et d'une première couche épitactique (2, 2' ; 6, 6') disposée avec tension sur le substrat, où des zones d'isolation (3, 3') par rapport à la surface de la première couche épitactique ou de la surface limite entre le substrat et la première couche épitactique porte dans la profondeur du substrat (1, 1') et où dans le substrat près de la surface limite (1, 1') à la première couche épitactique (2, 2' ; 6, 6'), est agencée localement, au moins une zone de défaut (5, 5') produite par implantation d'ions entre les zones d'isolation (3, 3'), est traitée thermiquement à faible température de sorte que localement, seules les zones (6, 6') de la première couche épitactique au-dessus de ladite au moins une zone de défaut (5, 5') relaxent au niveau de la tension, ce par quoi les zones restantes (2, 2') de la première couche épitactique conservent leur état de tension.

2. Procédé selon la revendication 1,
**caractérisé en ce**
**qu'**une suite de couches est traitée, où les zones d'isolation (3, 3') portent en partant de la surface de la première couché épitactique dans la profondeur du substrat.

3. Procédé selon l'une des revendications 1 ou 2,
**caractérisé en ce**
**qu'**une suite de couches est traitée, où ladite au moins une zone de défaut (5, 5') est formée à l'aide d'un masque.

4. Procédé selon l'une des revendications 1 à 3,
**caractérisé en ce**
**qu'**une suite de couches est traitée, où ladite au moins une zone de défaut (5, 5') est formée par implantation d'ions avec des ions d'hélium, ou des ions d'hydrogène, de bore, de phosphore, d'arsenic, de silicium, de germanium, d'antimoine, de soufre, de néon, d'argon ou de xénon.

5. Procédé selon la revendication 4,
**caractérisé en ce**
**qu'**une suite de couches est traitée, où ladite au moins une zone de défaut (5, 5') est produite par une implantation d'ions hélium ou hydrogène et avant l'implantation des ions hélium ou hydrogène, on réalise une implantation avec du silicium, du germanium ou des gaz inertes pour la nucléation de petites bulles d'hélium ou d'hydrogène.

6. Procédé selon l'une des revendications précédentes,
**caractérisé par**
le choix de la suite de couches avec en particulier, le silicium ou le silicium-germanium (SiGe), SiC, le saphir ou une perovskite oxyde comme substrat (1, 1').

7. Procédé selon l'une des revendications précédentes,
**caractérisé par**
le choix de la suite de couches avec en particulier, le silicium-germanium (SiGe), ou des composés semi-conducteurs des groupes III-V, des nitrures de III-V (AlN, GaN ou InN) ou des groupes II-VI du système périodique, ou des perovskites oxydes comme matériau de la première couche épitactique (2, 2' ; 6, 6').

8. Procédé selon la revendication 6 ou 7,
**caractérisé par**
un traitement thermique de 10 minutes à 850°C sous une atmosphère de N₂ pour la relaxation de la tension du silicium-germanium comme première couche épitactique (2) sur un substrat en silicium (1).

9. Procédé selon la revendication 6 ou 7,
**caractérisé par**
un traitement thermique de 10 minutes à 850°C sous une atmosphère d'argon ou de O₂ pour la relaxation de la tension du silicium-germanium comme première couche épitactique (2) sur un substrat en silicium (1).

10. Procédé selon l'une des revendications précédentes,
**caractérisé en ce**
**qu'**après le traitement thermique, des parties des zones soumises à des tensions internes de la première couche épitactique sont éliminées, de sorte que le substrat se trouvant dessous est libéré et que les zones relaxées au niveau de la tension de la première couche épitactique se situent au-dessus de ladite au moins une zone de défaut dans un premier plan près des zones soumises à des tensions internes de la première couche épitactique et près du substrat relaxé au niveau de la tension.

11. Procédé selon l'une des revendications précédentes,
**caractérisé en ce**
**qu'**après le traitement thermique, au moins une autre, deuxième couche épitactique (7, 7'), en particulier en silicium ou en silicium-germanium avec une teneur en germanium différente de la première couche épitactique en silicium-germanium, est déposée sous tension, sur toute la surface ou localement sur la suite de couches.

12. Procédé selon la revendication 11,
**caractérisé en ce**
**que** la première couche épitactique est une couche de SiGe soumise à des tensions internes, sur laquelle au moins une autre couche épitactique en silicium est déposée de manière localement limitée.

13. Procédé selon la revendication 11,
**caractérisé par**
une épaisseur de la première couche épitactique avec la deuxième couche épitactique d'environ 100 à 200 nm, de sorte que la planarité des différentes zones de silicium et de silicium-germanium (1, 2, 6, 7) ainsi que la conductibilité thermique au substrat (1) sont garanties.

14. Procédé selon l'une des revendications précédentes 11 à 13,
dans lequel une couche de renforcement (18) pour la stabilisation de la suite de couches est déposée sur celle-ci, où la couche de renforcement est déposée en particulier par une couche en silicium non soumise à des tensions internes (16') sur la couche de silicium-germanium (2') soumise à des tensions internes ainsi qu'une couche déposée sur celle-ci de silicium soumise à des tensions internes (7') sur le silicium-germanium (6') relaxé au niveau de la tension.

15. Procédé selon la revendication 14,
**caractérisé par**
le dépôt d'un masque (4') sur la couche de renforcement (18).

16. Procédé selon l'une des revendications précédentes 11 à 13,
**caractérisé par**
des shallow trench isolations (STI), des deep trench isolations ou des LOCOS en tant que zones d'isolation (3, 3').

17. Procédé selon la revendication 11,
**caractérisé en ce**
**que** comme deuxième couche épitactique (7, 7'), une couche en germanium ou une couche multiple est déposée sur toute la surface ou sélectivement.

18. Procédé selon la revendication 11,
**caractérisé en ce**
**que** dans le cas du silicium-germanium (SiGe) comme deuxième couche épitactique (7, 7') sur le silicium-germanium (SiGe) comme première couche épitactique (6, 6'), la concentration en germanium de la deuxième couche épitactique en silicium-germanium (7, 7') est supérieure que dans la première couche épitactique en silicium-germanium (6, 6').

19. Procédé selon l'une des revendications précédentes 11 à 13,
**caractérisé en ce**
**qu'**une implantation en cuve est réalisée pour la préparation d'un élément et l'implantation de défaut est réalisée pour la relaxation des tensions internes avec le même masque.

20. Procédé selon l'une des revendications précédentes 11 à 13,
**caractérisé en ce**
**que** les zones choisies d'isolation (3, 3') sont éliminées au moins jusqu'à la profondeur de la première couche épitactique (2, 2', 6, 6'), en particulier par corrosion.

21. Procédé selon l'une des revendications précédentes 11 à 13,
**caractérisé en ce**
**que** la première couche épitactique (2, 2', 6, 6') est éliminée au moins localement, pour produire du silicium soumis à des tensions internes sur le « nothing » (silicon on nothing, SON).

22. Procédé selon la revendication 21,
**caractérisé en ce**
**que** les zones éliminées sur la première couche épitactique (2, 2', 6, 6') sont remplies d'un isolant (17, 17'), pour produire le silicon on insulator (SOI).

23. Procédé selon l'une des revendications précédentes 11 ou 13,
**caractérisé en ce**
**que** la deuxième couche épitactique est en silicium et dans cette couche (7), des canaux MOSFET n sont produits.

24. Procédé selon l'une des revendications précédentes 11 ou 13,
**caractérisé en ce**
**que** la deuxième couche épitactique est en silicium-germanium et dans cette couche (7), des canaux MOSFET p sont produits.

25. Elément avec une suite de couches, comprenant une couche monocristalline épitactique (2, 2' ; 6, 6') avec états de tension localement différents sur un substrat (1, 1'), où des zones d'isolation (3, 3') de la surface de la couche épitactique ou de la surface limite entre le substrat et la couche épitactique porte dans la profondeur du substrat (1, 1') et où dans le substrat près de la surface limite (1, 1') à la couche épitactique (2, 2' ; 6, 6'), est agencée localement, au moins une zone de défaut (5, 5') produite par implantation d'ions entre les zones d'isolation (3, 3'), et les zones (6, 6') de la couche épitactique au-dessus de la au moins une zone de défaut (5, 5') relaxent au niveau de la tension, où les zones restantes (2, 2') de la couche épitactique sont soumises à des tensions internes.
